# FASCICULE DE BREVET EUROPEEN

(11) **EP 3 347 769 B1**
(45) Date de publication et mention de la délivrance du brevet: **07.08.2019**
(21) Numéro de dépôt: 16763794.1
(22) Date de dépôt: 09.09.2016
(51) Int. Cl.: G03F 7/00

(54) **PROCÉDÉ DE GRAVURE SÉLECTIVE D'UN COPOLYMÈRE À BLOCS**
VERFAHREN ZUM SELEKTIVEN ÄTZEN EINES BLOCKCOPOLYMERS
METHOD FOR SELECTIVE ETCHING OF A BLOCK COPOLYMER

(30) Priorité: 11.09.2015 FR 1558483
(43) Date de publication de la demande: 18.07.2018
(73) Titulaire: Commissariat à l'Énergie Atomique et aux Énergies Alternatives, 75015 Paris (FR)
(72) Inventeur: POSSEME, Nicolas, 38360 Sassenage (FR); SARRAZIN, Aurélien, 38000 Grenoble (FR)
(74) Mandataire: Cabinet Camus Lebkiri
(86) Numéro de dépôt international: PCT/EP2016/071268
(87) Numéro de publication internationale: WO 2017/042313

(56) Documents cités:
- EP-A2- 2 733 533
- OMURA M ET AL: "Highly selective etch gas chemistry design for precise DSAL dry development process", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9054, 28 mars 2014 (2014-03-28), pages 905409-905409, XP060031220, DOI: 10.1117/12.2046145 ISBN: 978-1-62841-730-2

## Description

### DOMAINE TECHNIQUE

La présente invention est relative aux techniques d'auto-assemblage dirigé de copolymères à blocs (« Directed Self-Assembly », DSA) permettant de générer des motifs de très hautes résolution et densité. L'invention concerne plus particulièrement un procédé de gravure permettant de retirer une première phase d'un copolymère à blocs sélectivement par rapport à une deuxième phase du copolymère à blocs.

### ÉTAT DE LA TECHNIQUE

La limite de résolution de la lithographie optique conduit à explorer de nouvelles techniques pour réaliser des motifs dont la dimension critique (CD) est inférieure à 22 nm. L'auto-assemblage dirigé de copolymères à blocs est considéré comme l'une des techniques de lithographie émergentes les plus prometteuses, en raison de sa simplicité et du faible coût de sa mise en oeuvre.

Les copolymères à blocs sont des polymères dans lesquels deux unités de répétition, un monomère A et un monomère B, forment des chaînes liées entre elles par une liaison covalente. Lorsque l'on donne suffisamment de mobilité aux chaînes, par exemple en chauffant ces copolymères à blocs, les chaînes de monomère A et les chaînes de monomère B ont tendance à se séparer en phases ou blocs de polymère et à se réorganiser sous des conformations spécifiques, qui dépendent notamment du ratio entre le monomère A et le monomère B. En fonction de ce ratio, on peut avoir des sphères de A dans une matrice de B, ou bien des cylindres de A dans une matrice de B, ou encore des lamelles de A et des lamelles de B intercalées. La taille des domaines du bloc A (respectivement du bloc B) est directement proportionnelle à la longueur des chaînes du monomère A (respectivement du monomère B). Les copolymères à blocs ont donc la propriété de former des motifs de polymère qui peuvent être contrôlés grâce au ratio des monomères A et B.

Les techniques connues d'auto-assemblage de copolymères à blocs (DSA) peuvent être regroupées en deux catégories, la grapho-épitaxie et la chémo-épitaxie.

La grapho-épitaxie consiste à former des motifs primaires appelés guides à la surface d'un substrat, ces motifs délimitant des zones à l'intérieur desquelles une couche de copolymère à blocs est déposée. Les motifs de guidage permettent de contrôler l'organisation des blocs de copolymère pour former des motifs secondaires de plus haute résolution à l'intérieur de ces zones. Les motifs de guidage sont classiquement formés par photolithographie dans une couche de résine.

Dans les techniques DSA par chémo-épitaxie, le substrat subit une modification chimique de sa surface de manière à créer des zones attirant préférentiellement un seul bloc du copolymère, ou des zones neutres n'attirant préférentiellement aucun des deux blocs du copolymère. Ainsi, le copolymère à blocs ne s'organise pas de manière aléatoire, mais selon le contraste chimique du substrat. La modification chimique du substrat peut notamment être obtenue par le greffage d'une couche de neutralisation appelée « brosse » (« brush layer » en anglais), par exemple formée d'un copolymère statistique.

Les techniques DSA permettent de réaliser différents types de motifs dans un substrat de circuit intégré. Après dépôt et assemblage du copolymère à blocs sur le substrat, les motifs secondaires sont développés en retirant l'un des deux blocs du copolymère, par exemple le bloc A, sélectivement par rapport à l'autre, formant ainsi des motifs dans la couche restante de copolymère (le bloc B). Si les domaines du bloc A sont des cylindres, les motifs obtenus après retrait sont des trous cylindriques. Par contre, si les domaines du bloc A sont des lamelles, on obtient des motifs en forme de tranchée rectiligne. Puis, ces motifs sont transférés par gravure à la surface du substrat, soit directement dans une couche diélectrique, soit au préalable dans un masque dur recouvrant la couche diélectrique.

Le copolymère à blocs PMMA-b-PS, constitué de polyméthacrylate de méthyle (PMMA) et de polystyrène (PS), est le plus étudié dans la littérature. En effet, les synthèses de ce copolymère à blocs et du copolymère statistique correspondant (PMMA-r-PS) sont faciles à réaliser et parfaitement maîtrisées. Le retrait de la phase de PMMA peut être réalisé par une gravure humide, éventuellement couplée à une exposition aux ultraviolets, ou par une gravure sèche utilisant un plasma.

La gravure humide du PMMA, par exemple dans un bain d'acide acétique, est une technique de retrait hautement sélective par rapport au polystyrène. La sélectivité, c'est-à-dire le rapport de la vitesse de gravure du PMMA sur la vitesse de gravure du polystyrène, est élevée (supérieure à 20:1). Toutefois, avec cette technique, des résidus de gravure se redéposent sur la couche de copolymère gravée, bouchant une partie des motifs obtenus dans la couche de polystyrène ce qui empêche leur transfert. En outre, dans le cas de domaines en forme de lamelles, la gravure humide peut provoquer un effondrement des structures de polystyrène dû aux forces de capillarité importantes.

La gravure sèche au plasma ne souffre pas de ces inconvénients et présente un intérêt économique fort, car l'étape de transfert des motifs qui suit l'étape de retrait du PMMA est également une gravure par plasma. Par conséquent, le même équipement peut être utilisé successivement pour ces deux étapes. Les plasmas habituellement utilisés pour graver la phase de PMMA sont générés à partir d'un mélange d'argon et d'oxygène (Ar/O₂) ou d'un mélange d'oxygène et de gaz fluorocarboné (ex. O₂/CHF₃). La gravure du PMMA à l'aide de ces plasmas s'effectue toutefois avec une sélectivité par rapport au polystyrène bien inférieure à celle de la gravure humide (respectivement de 4,2 et 3,5).

Ainsi, d'autres plasmas ont été développés afin d'augmenter la sélectivité de la gravure (sèche) du PMMA. Par exemple, dans l'article [« Highly selective etch gas chemistry design for precise DSAL dry development process », M. Omura et al., Advanced Etch Technology for Nanopatterning III, Proc. SPIE Vol. 9054, 905409, 2014], les auteurs montrent qu'un plasma de monoxyde de carbone (CO) permet de graver le PMMA avec une sélectivité quasi-infinie. En effet, le PMMA est gravé par le plasma CO sans que le polystyrène ne soit impacté, car un dépôt carboné se forme simultanément sur le polystyrène.

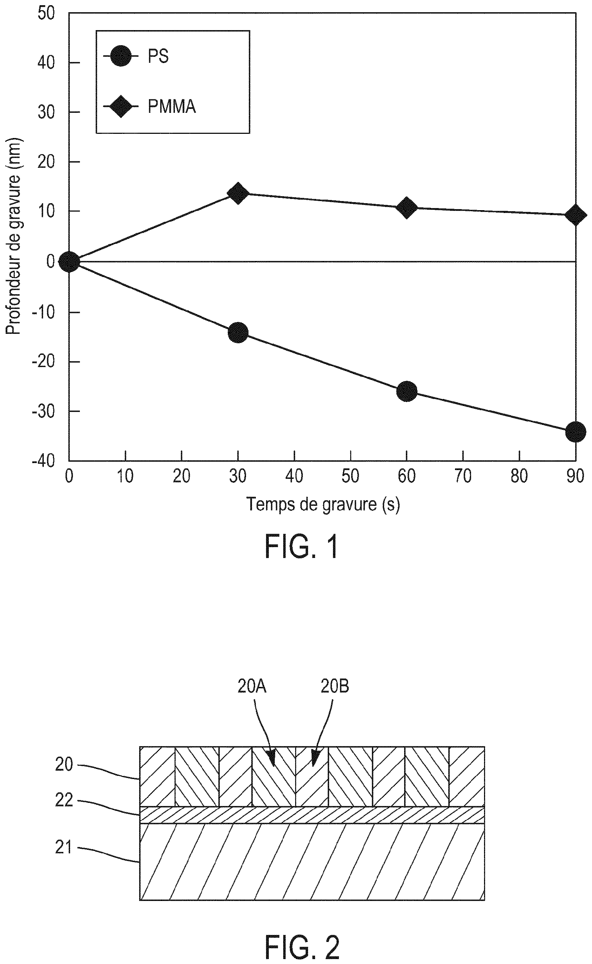

La figure 1 est un graphique qui représente la profondeur de gravure dans une couche de PMMA et dans une couche de polystyrène (PS) au cours de la gravure par le plasma CO. Elle illustre la différence de régimes entre les deux couches : régime de gravure dans le cas de la couche de PMMA (profondeur de gravure positive) et régime de dépôt dans le cas de la couche de PS (profondeur de gravure négative).

Lorsque ce gaz est utilisé seul, un phénomène de saturation se produit à environ 30 s de gravure, entraînant un arrêt de la gravure du PMMA. En effet, le régime de dépôt prend progressivement le dessus sur le régime de gravure et la gravure du PMMA est arrêtée à une profondeur de gravure d'environ 15 nm par la formation d'une couche carbonée sur la couche partiellement gravée de PMMA. Il n'est donc pas possible de graver plus de 15 nm d'épaisseur de PMMA avec ce seul gaz.

Pour remédier à ce problème de saturation, le monoxyde de carbone est mélangé à de l'hydrogène (H₂) en concentration inférieure ou égale à 7% et le plasma est généré à une puissance de polarisation d'environ 80 W. On constate dans la pratique que ce mélange de gaz présente une sélectivité de gravure bien inférieure à celle du monoxyde de carbone seul, car l'ajout d'hydrogène inhibe le dépôt de la couche carbonée sur le polystyrène. Le polystyrène est alors gravé en même temps que le PMMA. Il en résulte un élargissement des motifs formés dans la couche de polystyrène (par rapport aux dimensions initiales des domaines de PMMA) et des difficultés pour transférer ces motifs dans le substrat. En effet, la couche de polystyrène utilisée comme masque lors de ce transfert risque de ne pas être suffisamment épaisse.

### RÉSUMÉ DE L'INVENTION

La présente invention a pour but de fournir un procédé de gravure sèche d'un copolymère à blocs qui présente une sélectivité de gravure élevée entre les phases ou blocs du copolymère et ne connaît aucune limite en termes de profondeur de gravure.

Selon l'invention, on tend vers cet objectif en prévoyant un procédé de gravure d'une couche de copolymère à blocs assemblé comprenant des première et seconde phases de polymère, le procédé de gravure comportant l'exposition de la couche de copolymère à blocs assemblé à un plasma de façon à graver la première phase de polymère et déposer simultanément une couche carbonée sur la deuxième phase de polymère, le plasma étant formé à partir d'un mélange de gaz comprenant un gaz dépolymérisant et un gaz de gravure choisi parmi les hydrocarbures.

Les hydrocarbures sont des composés organiques constitués exclusivement d'atomes de carbone (C) et d'hydrogène (H). Leur formule brute est de la forme CₓH_{y}, où x et y sont des nombres entiers naturels non-nuls.

A l'instar du monoxyde de carbone (CO), un hydrocarbure gazeux peut, lorsqu'il est mélangé à un gaz dépolymérisant, donner naissance à un plasma permettant à la fois de graver la première phase d'un copolymère à blocs et de recouvrir d'un dépôt carboné (plutôt que de graver) la deuxième phase du copolymère. Ainsi, le procédé de gravure selon l'invention est aussi sélectif que le procédé de l'art antérieur, dans lequel le plasma est formé en utilisant du monoxyde de carbone uniquement. Cependant, à la différence de la gravure par le plasma CO, la gravure par un hydrocarbure ne présente aucun phénomène de saturation. La gravure de la première phase du copolymère à blocs se poursuit tant que la couche de copolymère est exposée au plasma. Autrement dit, le procédé de gravure selon l'invention n'est pas limité en termes d'épaisseur de la couche de copolymère à blocs.

De préférence, le procédé de gravure présente un rapport du débit de gaz de gravure sur le débit de gaz dépolymérisant compris entre 0,9 et 1,4.

Le procédé selon l'invention peut également présenter une ou plusieurs des caractéristiques ci-dessous, considérées individuellement ou selon toutes les combinaisons techniquement possibles :
- le gaz de gravure est du méthane ;
- le gaz de gravure est de l'éthane ;
- la couche de copolymère à blocs assemblé est exposée au plasma jusqu'à graver entièrement la première phase de polymère ;
- la première phase de polymère est organique et présente une concentration en atomes d'oxygène supérieure à 20 % ;
- la deuxième phase de polymère présente une concentration en atomes d'oxygène inférieure à 10 % ; et
- le gaz dépolymérisant est choisi parmi H₂, N₂, O₂, Xe, Ar et He

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1, précédemment décrite, représente la profondeur de gravure dans une couche de PMMA et dans une couche de polystyrène (PS) lors d'une gravure par un plasma de monoxyde de carbone ;
- la figure 2 représente un exemple de couche d'un copolymère à blocs assemblé avant la mise en oeuvre du procédé de gravure selon l'invention ;
- la figure 3 représente la profondeur de gravure dans une couche de PMMA et dans une couche de polystyrène (PS) en fonction du temps d'exposition à un plasma d'hydrocarbure/gaz dépolymérisant ; et
- les figures 4A et 4B représentent l'évolution de la couche de copolymère de la figure 2 au cours du procédé de gravure selon l'invention.

Pour plus de clarté, les éléments identiques ou similaires sont repérés par des signes de références identiques sur l'ensemble des figures.

### DESCRIPTION DÉTAILLÉE D'AU MOINS UN MODE DE RÉALISATION

La figure 2 montre une couche 20 de copolymère à blocs assemblé avant qu'elle ne soit gravée grâce au procédé de gravure selon l'invention. La couche de copolymère 20 comprend des première et deuxième phases de polymère, notées respectivement 20A et 20B, qui s'organisent en domaines. Le copolymère de la couche 20 est par exemple le copolymère di-bloc PS-*b*-PMMA, c'est-à-dire un copolymère constitué de polyméthacrylate de méthyle (PMMA) et de polystyrène (PS). La phase de polymère 20A correspond ici au PMMA et la phase de polymère 20B au polystyrène.

Une façon d'obtenir cette couche de copolymère à blocs 20 consiste à déposer le copolymère à blocs PS-*b*-PMMA sur un substrat 21 recouvert d'une couche de neutralisation 22. La couche de neutralisation 22 permet la séparation des phases 20A-20B lors de l'étape d'assemblage du copolymère à bloc, autrement dit l'organisation des domaines du copolymère. Elle est par exemple formée d'une couche de copolymère statistique PS-*r*-PMMA. De préférence, les domaines de PMMA (phase 20A) sont orientés perpendiculairement au substrat 21 et s'étendent sur toute l'épaisseur de la couche de copolymère 20. Suivant le ratio entre PMMA et polystyrène dans le copolymère PS-*b*-PMMA, les domaines de PMMA peuvent être en forme de cylindres (on parle alors de copolymère à blocs cylindrique) ou de lamelles (copolymère à blocs lamellaire).

Le procédé de gravure par plasma décrit ci-après vise à graver la phase du copolymère contenant le plus d'atomes d'oxygène (la phase de PMMA 20A dans l'exemple ci-dessus) sélectivement par rapport à l'autre phase (la phase de polystyrène 20B), et ce quelle que soit l'épaisseur de la couche de copolymère 20. A cette fin, la couche de copolymère 20 est exposée à un plasma généré à partir d'un mélange comprenant au moins un hydrocarbure gazeux CₓH_{y} et un gaz dépolymérisant dénommé ci-après « Z ».

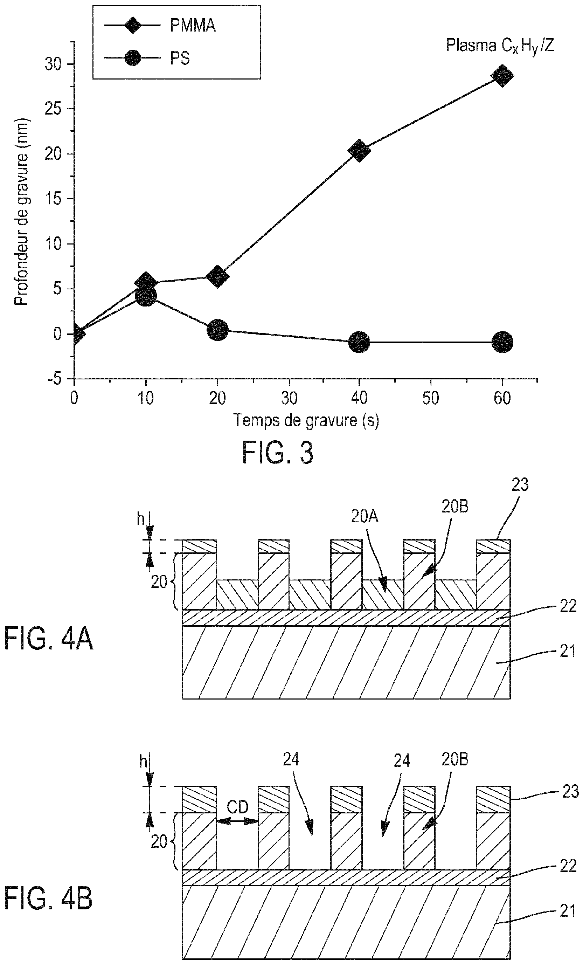

De façon analogue à la figure 1, la figure 3 représente en fonction du temps de gravure les profondeurs de gravure atteintes dans une couche de PMMA et dans une couche de polystyrène (PS) grâce à ce type de plasma. Comme le plasma CO (Fig.1), le plasma CₓH_{y}/Z possède un comportement différent selon le matériau de la couche. Le plasma CₓH_{y}/Z agit en régime de gravure sur la couche de PMMA (représenté par une profondeur de gravure positive) et en régime de dépôt concernant la couche de PS (représenté par une profondeur de gravure négative).

Le plasma CₓH_{y}/Z permet donc d'atteindre une sélectivité élevée entre le PMMA et le polystyrène dans la mesure où le polystyrène n'est pas gravé contrairement au PMMA. On remarque en outre sur la figure 3 que la profondeur de gravure du plasma CₓH_{y}/Z dans la couche de PMMA ne sature pas. Au contraire, elle ne cesse d'augmenter au fur et à mesure de la gravure. Cela signifie que la gravure par le plasma CₓH_{y}/Z n'est pas limitée en termes d'épaisseur de la couche de PMMA, contrairement au plasma CO.

Les figures 4A et 4B représentent l'évolution de la couche de copolymère 20 lorsque celle-ci est exposée au plasma CₓH_{y}/Z, d'après le procédé de gravure selon l'invention. La phase de PMMA 20A de la couche de copolymère 20 est progressivement gravée, tandis qu'une couche carbonée 23 se forme au-dessus de la phase de polystyrène 20B (Fig.4A). Puisque le plasma CₓH_{y}/Z n'est soumis à aucun phénomène de saturation, la phase de PMMA 20A peut être gravée entièrement quelle que soit son épaisseur, en continuant d'appliquer le plasma sur la couche de copolymère 20 (Fig.4B). Pour une couche de copolymère 20 d'épaisseur comprise entre 20 nm et 50 nm, le temps nécessaire pour graver entièrement la phase de PMMA 20A varie entre 20 s et 60 s. L'épaisseur h de la couche carbonée 23 augmente au cours de la gravure du PMMA, conformément à l'enseignement de la figure 3. A la fin de la gravure, l'épaisseur h peut être comprise entre 1 nm et 3 nm.

Le retrait total de la phase de PMMA, représenté sur la figure 4B, forme des motifs 24 dans une couche 20 désormais composée uniquement de la phase de polystyrène 20B. Ces motifs 24, en forme de trous cylindres ou de tranchées rectilignes, débouchent sur la couche de neutralisation 22 recouvrant le substrat 21.

Le procédé de gravure de la couche de copolymère 20 est avantageusement réalisé en une seule étape dans un réacteur à plasma, soit un réacteur à couplage capacitif (CCP, pour « Capacitively Coupled Plasmas » en anglais) soit un réacteur à couplage inductif (ICP, pour « Inductively Coupled Plasmas »).

L'hydrocarbure sous forme gazeuse est de préférence un alcane, tel que le méthane (CH₄) ou l'éthane (C₂H₆), c'est-à-dire un hydrocarbure saturé. Les ions de cet hydrocarbure détruisent les chaînes du polymère PMMA en consommant l'oxygène qu'elles contiennent. Ils sont également à l'origine de la formation de la couche carboné 23 sur le polystyrène, ce dernier étant insensible à la gravure car ne contenant pas d'oxygène. Les ions du gaz dépolymérisant empêchent la modification chimique en surface du PMMA en limitant le taux de polymérisation de l'hydrocarbure avec ce matériau. Autrement dit, ils empêchent la formation d'un polymère à la surface du PMMA. Ainsi, la couche carbonée 23 ne recouvre pas la phase de PMMA 20A. Le gaz dépolymérisant est par exemple choisi parmi H₂, N₂, O₂, Xe, Ar et He.

Le gaz hydrocarbure CₓH_{y} et le gaz dépolymérisant Z ont des débits d'entrée dans le réacteur à plasma dans un rapport CₓH_{y}/Z compris de préférence entre 0,9 et 1,4. Ce rapport de débits est d'autant plus grand que le nombre (x) d'atomes de carbone dans l'hydrocarbure (CₓH_{y}) est important. Il est par exemple compris entre 0,9 et 1,2 dans le cas du méthane (CH₄). Le débit d'hydrocarbure et le débit de gaz dépolymérisant entrant dans la chambre du réacteur sont de préférence compris entre 10 sccm et 500 sccm (abréviation de «Standard Cubic Centimeter per Minute » en anglais, soit le nombre de cm³ de gaz s'écoulant par minute dans les conditions standard de pression et de température, i.e. à une température de 0 °C et une pression de 1013,25 hPa).

Les autres paramètres de la gravure plasma CₓH_{y}/Z sont avantageusement les suivants :
- une puissance (RF) émise par la source du réacteur comprise entre 50 W et 500 W ;
- une puissance (DC ou RF) de polarisation du substrat comprise entre 50 W et 500 W ;
- une pression dans la chambre du réacteur comprise entre 2,67 Pa (20 mTorr) et 16,00 Pa (120 mTorr).

A titre d'exemple, le plasma est généré dans un réacteur CCP en mélangeant du méthane (CH₄) et du diazote (N₂), avec des débits de 25 sccm et 25 sccm respectivement, et en appliquant une puissance de source de 300 W et une puissance de polarisation de 60 W sous une pression de 4,00 Pa (30 mTorr). Ce plasma permet de retirer en 40 secondes une épaisseur de PMMA de 30 nm environ et de déposer dans le même laps de temps une couche carbonée de 3 nm d'épaisseur sur le polystyrène.

La sélectivité de gravure du PMMA par rapport au polystyrène grâce au plasma CₓH_{y}/Z est particulièrement élevée compte tenu que la phase de polystyrène 20B est recouverte de la couche carbonée 23, au lieu d'être gravée. Divers essais ont été menés et montrent que la phase PMMA d'une couche de copolymère PS-*b*-PMMA de 50 nm d'épaisseur peut être entièrement gravée en ne consommant pas de polystyrène. La sélectivité PMMA/PS du procédé de gravure est supérieure ou égale à 50. En conséquence, il est possible de garder constante la dimension critique CD des motifs 24 lors du retrait du PMMA (Fig.4B). Par dimension critique, on entend la plus petite dimension des motifs 24 obtenus par le développement du copolymère à blocs.

Malgré les différences des conditions de plasma entre les figures 1 et 3, les deux chimies de retrait du PMMA sélectivement au PS peuvent être comparées. Sur la figure 3, aucun phénomène de saturation n'est détecté pour la chimie à base de CₓH_{y}/Z à 30 s contrairement à la chimie en CO représentée sur la figure 1. Cette non-saturation de la gravure du PMMA s'accompagne d'un léger dépôt carboné sur le polystyrène. Ce dépôt facilite grandement l'étape de transfert des motifs 24 dans le substrat 21, qui suit l'étape de retrait de la phase de PMMA 20A (après ouverture de la couche de neutralisation 22). En effet, la phase de polystyrène 20B qui sert de masque de gravure lors de ce transfert est renforcée par la présence de la couche carbonée 23. Le masque de gravure étant plus épais, les contraintes qui pèsent sur le choix du plasma pour réaliser le transfert des motifs 24 peuvent être relâchées.

Bien qu'il ait été décrit en prenant le copolymère PS-*b*-PMMA en exemple, le procédé de gravure selon l'invention est applicable à tous copolymères à blocs comprenant une première phase de polymère organique (20A) riche en oxygène, c'est-à-dire ayant une concentration en atomes d'oxygène supérieure à 20 %, et une deuxième phase de polymère (organique ou inorganique) pauvre en oxygène, i.e. ayant une concentration en atomes d'oxygène inférieure à 10%. C'est le cas notamment des copolymères di-blocs PS-b-PLA, PDMS-*b*-PMMA, PDMS-*b*-PLA, PDMSB-b-PLA, etc. Le copolymère à blocs peut être soit de type cylindrique, soit de type lamellaire.

Enfin, la couche de copolymère à blocs organisé peut évidemment être obtenue d'une manière différente de celle décrite ci-dessus en relation avec la figure 2, notamment par grapho-épitaxie, par chémo-épitaxie en utilisant une couche de neutralisation autre qu'un copolymère statistique (par exemple une monocouche auto-assemblée, SAM), ou par une technique hybride mêlant grapho-épitaxie et chémo-épitaxie.

## Revendications

1. Procédé de gravure d'une couche (20) de copolymère à blocs assemblé comprenant des première et seconde phases de polymère (20A-20B), le procédé de gravure comportant l'exposition de la couche (20) de copolymère à blocs assemblé à un plasma de façon à graver la première phase de polymère (20A) et déposer simultanément une couche carbonée (23) sur la deuxième phase de polymère (20B), le procédé de gravure étant **caractérisé en ce que** le plasma est formé à partir d'un mélange de gaz comprenant un gaz dépolymérisant (Z) et un gaz de gravure choisi parmi les hydrocarbures (CₓH_{y}).

2. Procédé selon la revendication 1, présentant un rapport du débit de gaz de gravure (CₓH_{y}) sur le débit de gaz dépolymérisant (Z) compris entre 0,9 et 1,4.

3. Procédé selon l'une des revendications 1 et 2, dans lequel le gaz de gravure (CₓH_{y}) est du méthane.

4. Procédé selon l'une des revendications 1 et 2, dans lequel le gaz de gravure (CₓH_{y}) est de l'éthane.

5. Procédé selon l'une quelconque des revendications 1 à 4, dans lequel la couche (20) de copolymère à blocs assemblé est exposée au plasma jusqu'à graver entièrement la première phase de polymère (20A).

6. Procédé selon l'une quelconque des revendications 1 à 5, dans lequel la première phase de polymère est organique (20A) présente une concentration en atomes d'oxygène supérieure à 20 %, et dans lequel la deuxième phase de polymère (20B) présente une concentration en atomes d'oxygène inférieure à 10 %.

7. Procédé selon l'une quelconque des revendications 1 à 6, dans lequel le gaz dépolymérisant est choisi parmi H₂, N₂, O₂, Xe, Ar et He.

## Patentansprüche

1. Ätzverfahren einer Schicht (20) aus zusammengesetztem Block-Copolymer, umfassend erste und zweite Polymerphasen (20A-20B), wobei das Ätzverfahren das Kontaktieren der Schicht (20) aus zusammengesetztem Block-Copolymer mit einem Plasma derart umfasst, dass die erste Polymerphase (20A) geätzt und gleichzeitig eine kohlenstoffhaltige Schicht (23) auf der zweiten Polymerphase (20B) aufgebracht wird, wobei das Ätzverfahren **dadurch gekennzeichnet ist, dass** das Plasma ausgehend von einer Gasschicht gebildet ist, die ein entpolymerisierendes Gas (Z) und ein Ätzgas umfasst, das aus Kohlenwasserstoffen (CₓH_{y}) ausgewählt ist:

2. Verfahren gemäß Anspruch 1, das ein Verhältnis des Ätzgasdurchsatzes (CₓH_{y}) zum Durchsatz des entpolymerisierenden Gases (Z) aufweist, der zwischen 0,9 und 1,4 inbegriffen ist.

3. Verfahren gemäß einem der Ansprüche 1 und 2, bei dem das Ätzgas (CₓH_{y}) Methan ist.

4. Verfahren gemäß einem der Ansprüche 1 und 2, bei dem das Ätzgas (CₓH_{y}) Ethan ist.

5. Verfahren gemäß irgendeinem der Ansprüche 1 bis 4, bei dem die Schicht (20) aus zusammengesetztem Block-Copolymer mit Plasma kontaktiert ist, bis die erste Polymerphase (20A) vollständig geätzt ist.

6. Verfahren gemäß irgendeinem der Ansprüche 1 bis 5, bei dem die erste Polymerphase organisch (20A) ist und eine Konzentration an Sauerstoffatomen von mehr als 20 % aufweist und bei der die zweite Polymerphase (20B) eine Konzentration an Sauerstoffatomen von weniger als 10 % aufweist.

7. Verfahren gemäß irgendeinem der Ansprüche 1 bis 6, bei dem das entpolymerisierende Gas aus H₂, N₂, O₂, Xe, Ar und He ausgewählt ist.

## Claims

1. Method for etching an assembled block copolymer layer (20) comprising first and second polymer phases (20A-20B), the etching method comprising exposing the assembled block copolymer layer (20) to a plasma so as to etch the first polymer phase (20A) and simultaneously to deposit a carbon layer (23) on the second polymer phase (20B), the etching method being **characterised in that** the plasma is formed from a gas mixture comprising a depolymerising gas (Z) and an etching gas selected among the hydrocarbons (CₓH_{y}).

2. Method according to claim 1, having a ratio of the flow rate of etching gas (CₓH_{y}) over the flow rate of depolymerising gas (Z) comprised between 0.9 and 1.4.

3. Method according to one of claims 1 and 2, wherein the etching gas (CₓH_{y}) is methane.

4. Method according to one of claims 1 and 2, wherein the etching gas (CₓH_{y}) is ethane.

5. Method according to any of claims 1 to 4, wherein the assembled block copolymer layer (20) is exposed to the plasma until the first polymer phase (20A) is entirely etched.

6. Method according to any of claims 1 to 5, wherein the first polymer phase is organic (20A) and has a concentration of oxygen atoms greater than 20 %, and wherein the second polymer phase (20B) has a concentration of oxygen atoms less than 10 %.

7. Method according to any of claims 1 to 6, wherein the depolymerising gas is selected among H₂, N₂, O₂, Xe, Ar and He.
